# EUROPEAN PATENT SPECIFICATION

(11) **EP 0 866 644 B1**
(45) Date of publication and mention of the grant of the patent: **26.10.2005**
(21) Application number: 98104929.9
(22) Date of filing: 18.03.1998
(51) Int. Cl.: H05B 33/10, H05B 33/12, H05B 33/14, H05B 33/22, H05B 33/04, G03C 7/12, G03C 7/30

(54) **Electroluminescence device**
Elektrolumineszente Vorrichtung
Dispositif électroluminescent

(30) Priority: 19.03.1997 JP 6698697
(43) Date of publication of application: 23.09.1998
(73) Proprietor: FUJI PHOTO FILM CO., LTD., Kanagawa-ken (JP)
(72) Inventor: Hirai, Hiroyuki, Minami-Ashigara-shi, Kanagawa (JP)
(74) Representative: Grünecker, Kinkeldey, Stockmair & Schwanhäusser Anwaltssozietät

(56) References cited:
- EP-A- 0 752 620
- EP-A- 0 802 453

## Description

The present invention relates to an electroluminescence device (hereinafter referred to as "EL"). More particularly, the present invention relates to an EL device having a color filter layer formed by using a silver halide color photographic material.

An organic EL device has recently been noted as a display element substitute for LCD. Such a device is described, for example, in "Yuki EL Sosi Kaihatsu Senryaku (Strategy for Development of Organic EL Element)", 1992, Science Forum, "Flat Panel Display 1997", page 224, 1996, Nikkei BP, "NIKKEI ELECTRONICS 1996. 1. 29 (No. 654)", page 85, Nikkei BP, "Monthly Display '96 July", page 72, Technotimes. Further, JP-A-7-220871 (The term "JP-A" as used herein means an "unexamined published Japanese patent application") discloses an organic electroluminescence device comprising at least a hole-transporting layer and an electron-transporting light-emitting layer having at least one dye dispersed in a polymer.

This organic EL device comprises a thin film layer which is made of an organic material laminate of a hole-transporting layer and an electron-transporting light-emitting layer and which is provided on a transparent substrate coated with a transparent electrode made of indium-tin oxide (ITO) or the like, and a metal electrode made of magnesium/silver or the like provided on said thin film layer. When a voltage is applied to this organic EL device, it undergoes injection of holes from ITO and injection of electrons from the metal electrode made of magnesium/silver or the like. The electrons and holes are connected again to each other in the vicinity of the interface of the organic layers on the light-emitting layer side to excite neighboring dye, causing emission of white light. The white light is then taken out of the EL device through a color filter layer provided to be interposed between the transparent electrode and the transparent substrate.

The advantage of such an organic EL device is that a high brightness and a drive at a low voltage and a low power can be realized with a simple layer structure by selecting a combination of light-emitting materials arbitrarily. However, the conventional organic EL device is disadvantageous in that the color filter layer which has heretofore been proposed to be incorporated therein is obtained by vacuum metallizing method, dyeing method, printing method, pigment dispersing method, electrodeposition method or resist electrodeposition transferring method, which requires a complicated production step, tends to provide the resulting color filter with pinholes or marks and gives a poor yield and precision.

EP 0 752 620 A discloses a method for manufacturing a multicolor filter array comprising a silver halide color photographic material wherein the color processing of the silver halide color material comprises a treatment of the color processed color material in a solution comprising at least one group III metal ion.

EP 0 802 453 A discloses a silver halide color photographic material comprising a support and at least three differently spectrally sensitized silver halide emulsion layers, wherein each layer comprises gelatin and a colour coupler in a weight ration ≤ 5.00, and at least on intermediate layer situated between two of said at least three emulsion layers.

An object of the present invention is to provide an EL device provided having a color filter layer, which can be produced with little or no pinholes or marks at a high yield by a simple production process.

The present invention also relates to a process for producing an EL device at a high yield with little or no pinholes or marks occurrence.

Other objects and effects of the present invention will be apparent from the following description.

The above described objects of the present invention have been achieved by providing the followings.
(1) An electroluminescence device comprising a transparent flexible plastic substrate having thereon at least:
   a color filter layer;
   a water-impermeable protective layer;
   a transparent electrode;
   at least one organic compound layer including a light-emitting layer, said organic compound layer containing a polymer compound; and
   a back electrode in this order,
   wherein said color filter layer has red, green and blue pixel patterns obtainable by a process which comprises:
   applying a coating solution of a silver halide photographic layer onto said transparent substrate to form a photographic material having at least three sensitive layers comprising
   a magenta coupler and a cyan coupler incorporated in a blue-sensitive emulsion layer,
   a yellow coupler and a cyan coupler incorporated in a green-sensitive emulsion layer and
   a yellow coupler and a magenta coupler incorporated in a red-sensitive emulsion layer as the color filter layer,
   patternwise exposing said silver halide color photographic material to light; and then
   subjecting the exposed silver halide color photographic material to color development; and
   wherein the transparent electrode is coated with a solution containing a polymer compound to form the organic compound layer.
(2) The electroluminescence device according to the above (1), wherein said at least one organic compound layer comprises a white light-emitting layer and at least one of a hole-transporting layer and an electron-transporting layer.
(3) The electroluminescence device according to the above (1) or (2), wherein said light-emitting layer comprises at least one emitting material molecularly dispersed in a polymer.
(4) The electroluminescence device according to any one of the above (1) to (3), wherein said at least on organic compound layer contains at least one light-emitting polymer material.
(5) The electroluminescence device according to any one of the above (1) to (4), wherein said silver halide color photographic material comprises at least three color light-sensitive layers having color sensitivites different from one another.
(6) The electroluminescence device according to any one of the above (1) to (5), wherein said color filter layer further has a black matrix.

The present invention also relates to a process for producing an electroluminescence device comprising a transparent substrate having thereon at least:
a color filter layer having red, green and blue pixel patterns;
a water-impermeable protective layer;
a transparent electrode;
at least one organic compound layer including a light-emitting layer, said organic compound layer containing a polymer compound; and a back electrode,
which process comprises pixel pattern formation comprising:
   applying a coating solution of a silver halide photographic layer onto a transparent substrate to form a photographic material having at least three sensitive layers comprising
   a magenta coupler and a cyan coupler incorporated in a blue-sensitive emulsion layer,
   a yellow coupler and a cyan coupler incorporated in a green-sensitive emulsion layer and
   a yellow coupler and a magenta coupler incorporated in a red-sensitive emulsion layer as the color filter layer;
   patternwise exposing said silver halide color photographic material to light; and then
   subjecting the exposed silver halide color photographic material to color development, to thereby form said pixel patterns on said transparent substrate and
wherein the transparent electrode is coated with a solution containing a polymer compound to form the organic compound layer.

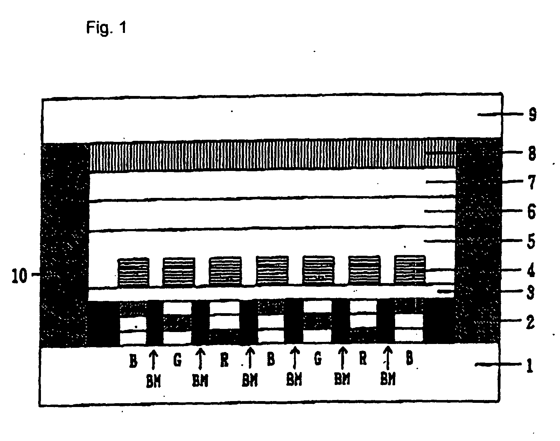

Fig. 1 is a diagram illustrating a section of an EL device according to the present invention.

The color filter layer to be incorporated in the EL device of the present invention is described in detail below.

In the present invention, a coating solution of a silver halide color photographic layer is applied onto a transparent substrate to form a silver halide light-sensitive material, from which a color filter layer is formed on the transparent substrate. The silver halide light-sensitive material preferably comprises at least three color light-sensitive layers each having a color sensitivity different from one another. The light-sensitive layers each comprises a color former (a coupler) incorporated therein so as to develop the respective color of blue, green and red (and, as needed, black) as a result of exposure and color development. A typical example of such an arrangement is an ordinary negative-working or positive-working color light-sensitive material comprising a yellow coupler incorporated in a blue-sensitive emulsion layer, a magenta coupler incorporated in a green-sensitive emulsion layer and a cyan coupler incorporated in a red-sensitive emulsion layer. Another typical example is a color light-sensitive material comprising a magenta coupler and a cyan coupler incorporated in a blue-sensitive emulsion layer, a yellow coupler and a cyan coupler incorporated in a green-sensitive emulsion layer and a yellow coupler and a magenta coupler incorporated in a red-sensitive emulsion layer.

The color sensitivity of the above-described silver halide photographic material is not limited to the combination of blue sensitivity, green sensitivity and red sensitivity. These color sensitivities may be combined with infrared sensitivity, ultraviolet sensitivity or yellow sensitivity. Further, a plurality of infrared-sensitive emulsion layers having different sensitive wavelength ranges may be used. The order of application of silver halide emulsion layers having different color sensitivities may be appropriately selected. In addition to the above-described layer structure, a subbing layer, an interlayer, a bleachable yellow filter layer, a protective layer, an ultraviolet-absorbing layer, etc. may be further provided as needed.

For the details of the color light-sensitive material employable herein, reference can be made to JP-A-55-6342, JP-A-62-148952, JP-A-62-71950, JP-A-8-136722, JP-A-7-244212, and JP-A-8-22108.

Other components of the color light-sensitive layer for forming the color filter layer for use in the present invention can be selected from known materials. For the details of these materials, reference can be made to RD Nos. 17,643, 18,716 and 307,105. The location of the relevant descriptions are shown below.

| | Kind of additive | RD17643 | RD18716 | RD307105 |
|---|---|---|---|---|
| 1. | Chemical sensitizer | p. 23 | p. 648 right column (RC) | p. 866 |
| 2. | Sensitivity increasing agent | | ditto | |
| 3. | Spectral sensitizer and supersensitizer | pp. 23-24 | p. 648 RC-p. 649 RC | pp. 866-868 |
| 4. | Fluorescent brightening agent | p. 24 | p.647 RC | p. 868 |
| 5. | Antifoggant and stabilizer | pp. 24-25 | p. 649 RC | pp.868-870 |
| 6. | Light absorbent, filter dye, and ultraviolet absorbent | pp. 25-26 | p. 649 RC-p. 650 left column (LC) | p. 873 |
| 7. | Color coupler | p. 25 RC | p. 649 RC | pp. 871-872 |
| 8. | Dye image stabilizer | p.25 | p. 650 LC | ditto |
| 9. | Hardening agent | p. 26 | p. 651 LC | pp. 874-875 |
| 10. | Binder | p. 26 | p. 650 LC | pp. 873-874 |
| 11. | Plasticizer and lubricant | p. 27 | p. 650 RC | p.876 |
| 12. | Coating aid and surface active agent | pp. 26-27 | ditto | pp. 875-876 |
| 13. | Antistatic agent | p. 27 | ditto | pp. 876-877 |

The material constituting the transparent substrate is preferably one having an excellent heat resistance. Examples of such a material include polyethylene terephthalate, polybutylene terephthalate, polyethylene naphthalate, polystyrene, polycarbonate, polyether sulfone, cellulose acetate, polyarylate, soda glass, borosilicate glass and quartz. The surface of the substrate made of these materials may be subjected to primary coating treatment as needed. Further, the surface of the substrate may be subjected to glow discharge, corona discharge, ultraviolet (UV) irradiation or the like. The transparent substrate may be used in the form of tablet, sheet, film or the like. The thickness of the substrate may be appropriately selected depending on the intended purpose and on the kind of the material used. The thickness is, however, generally from 0.01 to 10 mm. For example, if the substrate is made of glass, its thickness is generally from 0.3 to 3 mm. In the present invention, the transparent substrate is a flexible plastic substrate preferably having a thickness of from 0.05 to 0.3 mm from the standpoint of producibility. In case where a plastic substrate is used, the substrate may have a gas barrier layer, a hard coat layer, etc. for inhibiting moisture and oxygen from permeating therethrough and for controlling the curl balance thereof.

In the present invention, the method for the application of a coating solution of a color light-sensitive layer onto the transparent substrate is not particularly limited. In the case of using a plastic substrate, a coating solution of a color light-sensitive layer is generally applied to a substrate which have been subjected to the above described primary coating treatment by a bar coating method, a spin coating method, a through coating method or a hopper coating method. In the case of using a glass substrate, the color light-sensitive layer may be formed by directly applying the coating solution onto the substrate by one of the above described coating methods. In addition, a color light-sensitive layer formed on a plastic substrate beforehand may be transferred to a glass substrate as described in JP-A-7-244212.

In the present invention, the above-described color photographic light-sensitive material is then subjected to exposure for forming blue, green and red pixel patterns and, as needed, a black stripe. The exposure method which can be used in the exposure step for use in the present invention may be any known method such as surface exposure process using a mask and scanning exposure process. Examples of the scanning method includes line (slit) scanning methods and point scanning methods by laser exposure. Examples of the light source for use herein include tungsten lamp, halogen lamp, fluorescent tube (e.g., three-wavelength type fluorescent tube), xenon lamp, mercury vapor lamp, laser and light-emitting diode. Particularly preferred among these light sources are halogen lamp, fluorescent tube and laser.

Thereafter, the thus exposed color light-sensitive material is subjected to an ordinary color development as described in Research Disclosure (RD) Nos. 17643 (pp. 28 - 29) and 18716 (left column to right column on page 651) to form a microcolor filter.

The color development process normally comprises color development step, desilvering step, rinsing step and drying step. In the desilvering step, a blix step using a blix solution may be effected instead of bleaching step using a bleaching solution and fixing step using a fixing solution. Alternatively, the bleaching step, the fixing step and the blix step may be combined in an arbitrary order. A stabilizing step may be effected instead of or after rinsing step. Further, a monobath processing step using a monobath developing, bleaching and fixing solution for effecting color development, bleaching and fixing in one bath may be effected. In combination with these processing steps, a pre-hardening step, a neutralizing step therefor, a stop and fixing step, a post-hardening step, an adjusting step, an intensifying step, etc. may be effected. In these steps, the color development step may be replaced by a so-called activator processing step.

As described in JP-A-7-159610, an internal latent image type auto positive emulsion may be subjected to color development and desilvering with a nucleating agent and a light fogging agent in combination.

A developing apparatus for use in the present invention may be one for use in ordinary photographic processing if the transparent substrate is flexible. In the case of hard substrate such as glass, a developing machine for glass dry plate or a developing apparatus as described in JP-A-7-56015 may be used.

The color filter thus prepared is preferably coated with a water-impermeable protective layer (overcoat layer) as an outermost layer of the color filter. The water-impermeable protective layer is generally heat-resistant and water-resistant and has a high specific electric resistivity. Preferred materials of the protective layer include the resins described in U.S. Patents 4,698,295 and 4,668,601, EP-179,636A, EP-556,810A, JP-A-3-163416, JP-A-3-188153, JP-A-5-78443, JP-A-1-276101, JP-A-60-216307, JP-A-63-218771 and Japanese Patent Application Nos. 8-238154 and 8-276027.

On the color filter, there may be preferably provided a single or multicomponent metal oxide glass layer (which functions as a water-impermeable protective layer) formed by a process which comprises: applying a reaction product obtained by the hydrolysis and dehydrocondensation of a hydrolyzable organic metal compound in a reaction solution made of water and an organic solvent with a halogen ion as a catalyst in the presence of boron ion while adjusting the pH value thereof to a range of from 4.5 to 5.0; and then vitrifying the reaction product at a temperature of not higher than 200°C. For the details of this technique, reference can be made to Japanese Patent Application No. 8-235621.

In the present invention, the method for the application of the composition forming the above-described protective layer is not particularly limited. Various methods such as spray coating method, bar coating method and spin coating method may be used.

On the color filter or protective layer thus prepared, further formed is a transparent electrode which acts as an anode by an evaporation method such as vacuum metallizing and sputtering. Examples of the transparent electrode include tin oxide (NESA), zinc oxide, indium oxide/tin oxide composite compound (ITO), indium oxide/zinc oxide compound, tin oxide/antimony oxide compound, gallium oxide/zinc oxide compound and electrically-conductive polymers such as polypyrrole, polyaniline and polymethylthiophene.

On the transparent electrode thus formed, at least one organic compound layer containing a light-emitting layer is further provided. On the organic compound layer, a back electrode (cathode) is further provided. Specific examples of the laminate structure include anode/hole-transporting layer/light-emitting layer/cathode, anode/light-emitting layer/electron-transporting layer/cathode, anode/hole-transporting layer/light-emitting layer/electron-transporting layer/cathode, and anode/light-emitting layer/cathode. However, the present invention is not limited to these structures. For example, these structures may have a plurality of light-emitting layers, hole-transporting layers and electron-transporting layers. Further, a plurality of light-emitting layers may be combined to form a white light-emitting layer. Furthermore, a hole-injecting layer or an electron-injecting layer may be provided. Moreover, a layer structure such as hole-transporting layer/light-emitting layer, light-emitting layer/electron-transporting layer and hole-transporting layer/light-emitting layer/electron-transporting layer may be repeatedly laminated. A particularly preferred light-emitting layer for use in the present invention is one disclosed in JP-A-7-220871 and JP-A-7-90260, which is provided with at least a hole-transporting layer and an electron-transporting light-emitting layer or with at least an electron-transporting layer and a hole-transporting light-emitting layer, in which the light-emitting layer has at least one light-emitting material dispersed in a polymer to form a white light-emitting layer. In addition, light-emitting polymer materials are preferably used. Examples of the light-emitting polymer material include polymers having a low molecular weight dye and tetraphenyldiamine or triphenylamine incorporated in their main or side chain, as well as π conjugated system polymers such as poly-p-phenylenevinylene derivatives.

These white light-emitting layers each preferably comprise a plurality of light-emitting materials molecularly dispersed in a polymer compound so that the resulting emission spectra widely covers the visible light range. Further, the electron-transporting light-emitting layer or hole-transporting light-emitting layer preferably comprises a light-emitting material molecularly dispersed in a polymer compound which is capable of transporting carrier by itself, or comprises a low molecular weight carrier-transporting agent and a light-emitting material molecularly dispersed in a polymer compound which is incapable of transporting carrier.

Moreover, an electron-transporting light-emitting layer and a hole-transporting light-emitting layer each comprising a light-emitting material having emission spectra different from each other dispersed in the respective layer may be laminated to form a white light-emitting layer as a whole.

The light-emitting material for use in the present invention is not particularly limited, and any materials which emits fluorescence when excited may be used. Examples thereof include oxinoid compounds, perylene compounds, coumarine compounds, azacoumarine compounds, oxazole compounds, oxadiazole compounds, perinone compounds, pyrrolopyrrole compounds, naphthalene compounds, anthracene compounds, fluorene compounds, fluoranthene compounds, tetracene compounds, pyrene compounds, coronene compounds, quinolone compounds, azaquinolone compounds, pyrazoline derivatives, pyrazolone derivatives, rhodamine compounds, chrysene compounds, phenanthrene compounds, cyclopentadiene compounds, stilbene compounds, diphenylquinone compounds, styryl compounds, distyrylbenzene compounds, butadiene compounds, dicyanomethylenepyran compounds, dicyanomethylenethiopyran compounds, fluorescein compounds, pyrilium compounds, thiapyrilium compounds, selenapyrilium compounds, telluropyrilium compounds, aromatic ardadiene compounds, oligophenylene compounds, xanthene compounds, thioxanthene compounds, cyanine compounds, acridine compounds, acridone compounds, quinoline compounds, metal complexes of 8-hydroxyquinoline compounds, benzoquinolinol berylium complex, metal complexes of 2,2'-bipyridine compounds, complexes of Schiff salt with a group III metal, metal complexes of oxadiazole compounds and rare earth metal complexs. Such a light-emitting material may be molecularly dispersed in a carrier-transporting polymer compound. Alternatively, a low molecular weight carrier-transporting material and a light-emitting material may be molecularly dispersed in a polymer compound incapable of transporting carrier.

The term "electron-transporting polymer compound" as used herein means a polymer compound containing an electron accepting group in its side or main chain. The term "hole-transporting polymer compound" as used herein means a polymer compound containing an electron donative group in its side or main chain. The term "polymer compound incapable of transporting carrier" as used herein means an electrically inert polymer compound such as polymethyl methacrylate, polymethyl acrylate, polystyrene and polycarbonate. The "low molecular weight carrier-transporting material" to be used when there are no carrier transporting properties means an electron-transporting (electron-accepting) or hole-transporting (electron donative) low molecular weight material.

Examples of the electron-transporting compound for use in the present invention include oxadiazole derivatives, triazole derivatives, triazine derivatives, nitro-substituted fluorenone derivatives, thiopyran dioxide derivatives, diphenylquinone derivatives, perylenetetracarboxyl derivatives, anthraquinodimethane derivatives, fluorenilidenemethane derivatives, anthrone derivatives, perinone derivatives, oxine derivatives and quinoline complex derivatives.

Examples of the hole-transporting compound for use in the present invention include polymer compounds such as poly-N-vinylcarbazole, polyphenylene vinylene derivatives, polyphenylene, polythiophene, polymethylphenylsilane and polyaniline, triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, carbazole derivatives, styrylanthracene derivatives, fluorenone derivatives, hydrazone derivatives, stilbene derivatives, poryphyrin derivatives such as phthalocyanine, aromatic tertiary amine and styrylamine compounds, butadiene compound, benzidine derivatives, polystyrene derivatives, triphenylmethane derivatives, tetraphenylbenzine derivatives and starbust polyamine derivatives.

Examples of the at least one organic compound layer containing a white light-emitting layer include one disclosed in JP-A-7-220871, which comprises a hole-transporting layer comprising a polyvinylcarbazole (PVK) having high hole-transporting ability and a light-emitting layer comprising an electron-transporting oxadiazole derivative (PBD) and a fluorescent dye, as a emission center, such as tetraphenylbutadiene (TPB), coumarine 6, DCM1 and Nile red, each incorporated in a polymethyl methacrylate (PMMA) in a small amount. These fluorescent dyes emit blue light (TPB), green light (coumarine 6), yellow light (DCM1) or red light (Nile red). When these fluorescent dyes emit concurrently, the resulting light becomes white light. For the details of the principle of the light emission, reference can be made to JP-A-7-220871.

Referring to the structure of the above-described example, an electron-transporting, white light-emitting layer is provided on a hole-transporting layer which has been provided in contact with a transparent electrode (anode) made of ITO or the like.

For retaining the adhesion between the anode and the hole-transporting layer, an anode interfacial layer having a thickness of about from 0.01 to 30 nm may be provided. Examples of a compound for use in the anode interfacial layer include condensed polycyclic dyes such as spiro compounds, azo compounds, quinone compounds, indigo compounds, diphenylmethane compounds, quinacridone compounds, polymethine compounds, acridine compounds and porphyrin compounds, and low molecular weight p-type semiconductor.

The incorporation of a polymer compound in the hole-transporting layer, electron-transporting layer and light-emitting layer allows the formation of these layers by application in the form of solution. Therefore, together with the application of a color light-sensitive layer and the use of a transparent plastic substrate for the formation of a color filter, the arrangement of the present invention allows an efficient production of EL device at a low cost. This is a feature of the present application. Additionally, the organic compound layer containing a polymer compound can be formed according to a known coating method such as dipping method, spin coating method, casting method, bar coating method, roll coating method, and the like. Further, simultaneous multi-layer coating of these layers becomes possible by appropriately selecting solvents for the respective layers.

On the above-described electron-transporting layer, a metal electrode is provided as a back electrode (cathode). Examples of the material for use in the back electrode include metals having a small work function such as magnesium, calcium, sodium, potassium, titanium, indium, yttrium, lithium, gadolinium, ytterbium, ruthenium, manganese, aluminum, silver, tin and lead, and alloys thereof. Further, a thin layer made of aluminum oxide or lithium fluoride having a thickness of about 0.01 to 30 nm may be interposed between the electron-transporting layer and the metal electrode. The back electrode may be an electrically-conductive coating layer (paste) as described in JP-A-7-85974. On the surface of the back electrode, there may be formed a protective layer (sealing layer) for blocking moisture. For the details of the protective layer for this purpose, reference can be made to JP-A-7-85974.

By forming the above-described transparent electrode and metal electrode crosswise to each other as described in JP-A-7-220871, and by applying a d.c. (which may have a.c. component, as needed) or a.c. voltage (normally, a pulse voltage of from 2 to 30 volt) across the two opposing electrodes, the point of intersection formed by the two opposing electrodes is rendered capable of emitting light, making it possible to cause the light-emitting layer to emit light. A simple matrix driving full-color display can be obtained by combining the above-described laminate with the above-described color filter layer (Fig. 1).

For driving the EL device of the present invention, the methods disclosed in JP-A-2-148687, JP-A-6-301355, JP-A-5-29080, JP-A-7-134558, JP-A-8-234683 and JP-A-8-241047 can be used.

Preferably, the back electrode closely contacts with a substrate. The substrate for use herein does not necessarily need to be transparent but may be light-screening. Although the material of this substrate may be appropriately selected from the group consisting of plastic, glass and metal, moisture and air impermeable materials are preferred. Desiccants or water repellant fluorine-based inert liquid may be interposed between the back electrode and the above-mentioned substrate.

The lamination of the above-mentioned substrate with the back electrode for sealing may be conducted using an adhesive after the formation of the back electrode on the organic compound layer such as the above-described electron-transporting layer by vacuum metallizing method, sputtering method, printing method or the like. Alternatively, the back electrode may be first formed on the substrate by vacuum metallizing method, sputtering method, printing method or the like, followed by the lamination with the organic compound layer to thereby seal.

One embodiment of the EL device according to the present invention is shown in Fig. 1 in the form of a diagram illustration, but the present invention is not limited to this constitution. Fig. 1 is a sectional view of an EL device of the present invention. This device has an arrangement such that a color filter layer 2, a protective layer 3, a transparent electrode (anode) 4, a hole-transporting layer 5, a white light-emitting layer 6, an electron-transporting layer 7 and a back electrode (cathode) 8 according to the present invention are provided between a transparent substrate 1 and a substrate 9 and sealed with sealants 10.

The present invention will be described in greater detail below with reference to the following Examples, but the invention should not be construed as being limited thereto.

### Reference EXAMPLE 1

A transparent polyether sulfone substrate (thickness : 150 µm) having a gas barrier layer and a hard coat layer was subjected to glow discharge treatment and coated with two layers (thickness: 0.1 µm), i.e., SBR latex layer and gelatin layer to facilitate the adhesion with a photographic emulsion layer. Onto the substrate, color light-sensitive layers were coated by a simultaneous multi-layer coating process to prepare a color photographic light-sensitive material (2A). The layer constitution of the color photographic light-sensitive material (2A) and details of the respective layers are shown in (A) below.

The photographic light-senoltive material thus prepared was stripewise exposed to white light through a mask filter, and then subjected to color development, desilvering and rinsing, to thereby prepare a color filter having 0.4 mm-wide R, G and B pixels and a 0.1 mm-wide black matrix. Details of the processing step used for the light-sensitive material (2A) are shown in (B) below.

The surface of the color filter was coated with a UV-curing type acrylate resin, which was then cured to form a protective layer thereon.

### (A) Layer Constitution

The components of the respective layers and the coating amount thereof (unit: g/m²) are shown below. With respect to the silver halide, the coating amount is calculated in terms of silver.

| First Layer (antihalation layer): | |
|---|---|
| Gelatin | 0.70 |
| Antihalation dye (fine particle dispersion) | 0.17 |
| Carboxymethyl cellulose | 0.05 |
| Surface active agent (Cpd-16) | 0.03 |
| Hardener (H-1) | 0.12 |

| Second Layer (infrared-sensitive layer): | |
|---|---|
| Silver halide emulsion spectrally sensitized by Infrared Sensitizing Dye (ExS-6) (AgBr₃₀Cl₇₀; average grain size: 0.2 µm) | 0.28 |
| Stabilizer (Cpd-12) | 0.005 |
| Gelatin | 0.57 |
| Cyan Coupler (ExC-2) | 0.10 |
| Yellow Coupler (ExY-1) | 0.35 |
| Magenta Coupler (ExM-1) | 0.14 |
| Discoloration Inhibitor (Cpd-3) | 0.05 |
| Discoloration Inhibitor (Cpd-4) | 0.005 |
| Discoloration Inhibitor (Cpd-5) | 0.02 |
| High Boiling Point Solvent (Solv-1) | 0.42 |
| High Boiling Point Solvent (Solv-2) | 0.10 |
| Stain Inhibitor (Cpd-13) | 0.01 |
| Polymer (Cpd-14) | 0.01 |

| Third Layer (interlayer): | |
|---|---|
| Gelatin | 0.38 |
| Color Mixing Inhibitor (Cpd-2) | 0.02 |
| Color Mixing Inhibitor (Cpd-10) | 0.09 |
| High Boiling Point Solvent (Solv-1) | 0.03 |
| High Boiling Point Solvent (Solv-3) | 0.01 |
| Ultraviolet Absorbent (Cpd-8) | 0.02 |
| Ultraviolet Absorbent (Cpd-7) | 0.02 |
| Ultraviolet Absorbent (Cpd-6) | 0.01 |
| Ultraviolet Absorbent (Cpd-9) | 0.02 |
| Stain Inhibitor (Cpd-11) | 0.04 |

| Fourth Layer (red-sensitive Layer): | |
|---|---|
| Silver halide emulsion spectrally sensitized by Red Sensitizing Dyes (ExS-4 and ExS-5) (AgCl; average grain size: 0.18 µm) | 0.31 |
| Gelatin | 0.77 |
| Yellow Coupler (ExY-1) | 0.53 |
| Magenta Coupler (ExM-2) | 0.29 |
| Discoloration Inhibitor (Cpd-3) | 0.06 |
| Discoloration Inhibitor (Cpd-4) | 0.005 |
| Discoloration Inhibitor (Cpd-5) | 0.01 |
| High Boiling Point Solvent (Solv-1) | 0.48 |
| High Boiling Point Solvent (Solv-2) | 0.12 |
| Polymer (Cpd-14) | 0.03 |

| Fifth Layer (interlayer): | |
|---|---|
| Gelatin | 0.38 |
| Color Mixing Inhibitor (Cpd-2) | 0.02 |
| Color Mixing Inhibitor (Cpd-10) | 0.09 |
| High Boiling Point Solvent (Solv-1) | 0.03 |
| High Boiling Point Solvent (Solv-3) | 0.01 |
| Ultraviolet Absorbent (Cpd-8) | 0.02 |
| Ultraviolet Absorbent (Cpd-7) | 0.02 |
| Ultraviolet Absorbent (Cpd-6) | 0.01 |
| Ultraviolet Absorbent (Cpd-9) | 0.02 |
| Stain Inhibitor (Cpd-11) | 0.04 |
| Irradiation Preventive Dye (Dye-1) | 0.005 |
| Irradiation Preventive Dye (Dye-2) | 0.02 |

| Sixth Layer (green-sensitive layer): | |
|---|---|
| Silver halide emulsion spectrally sensitized by Green Sensitizing Dye (ExS-3) (AgCl; average grain size: 0.18 µm) | 0.43 |
| Gelatin | 1.09 |
| Cyan Coupler (ExC-1) | 0.33 |
| Yellow Coupler (ExY-1) | 0.43 |
| Discoloration Inhibitor (Cpd-5) | 0.01 |
| Stain Inhibitor (Cpd-13) | 0.01 |
| High Boiling Point Solvent (Solv-1) | 0.08 |
| High Boiling Point Solvent (Solv-2) | 0.11 |
| Polymer (Cpd-14) | 0.03 |

| Seventh layer (interlayer): | |
|---|---|
| Gelatin | 0.38 |
| Color Mixing Inhibitor (Cpd-2) | 0.02 |
| Color Mixing Inhibitor (Cpd-10) | 0.09 |
| High Boiling Point Solvent (Solv-1) | 0.03 |
| High Boiling Point Solvent (Solv-3) | 0.01 |
| Ultraviolet Absorbent (Cpd-8) | 0.02 |
| Ultraviolet Absorbent (Cpd-7) | 0.02 |
| Ultraviolet Absorbent (Cpd-6) | 0.01 |
| Ultraviolet Absorbent (Cpd-9) | 0.02 |
| Stain Inhibitor (Cpd-11) | 0.04 |
| Yellow Dye (YF-1) | 0.17 |

| Eighth Layer (blue-sensitive layer): | |
|---|---|
| Silver halide emulsion spectrally sensitized by Blue Sensitizing Dyes (ExS-1 and ExS-2) (AgBr₃₀Cl₇₀; average grain size: 0.35 µm) | 0.33 |
| Gelatin | 1.00 |
| Cyan Coupler (ExC-2) | 0.57 |
| Ultraviolet Absorbent (Cpd-6) | 0.03 |
| Ultraviolet Absorbent (Cpd-7) | 0.08 |
| High Boiling Point Solvent (Solv-1) | 0.23 |

| Ninth Layer (protective layer): | |
|---|---|
| Gelatin (acid-processed) | 0.51 |
| Antistatic agent (Cpd-1) | 0.03 |
| Snowtex-O (produced by Nissan Kagaku Kogyo KK) | 0.16 |

In each layer, sodium dodecylbenzenesulfonate as an emulsification dispersion aid, ethyl acetate as an auxiliary solvent, Surface Active Agent (Cpd-17) as a coating aid and potassium polystyrenesulfonate as a thickening agent were used.

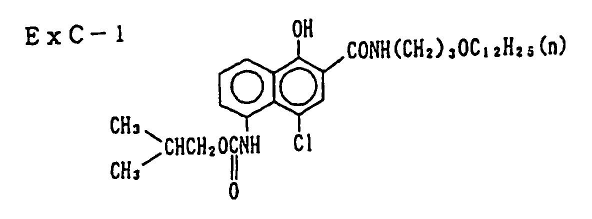

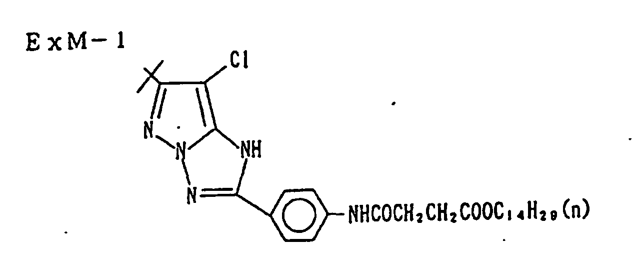

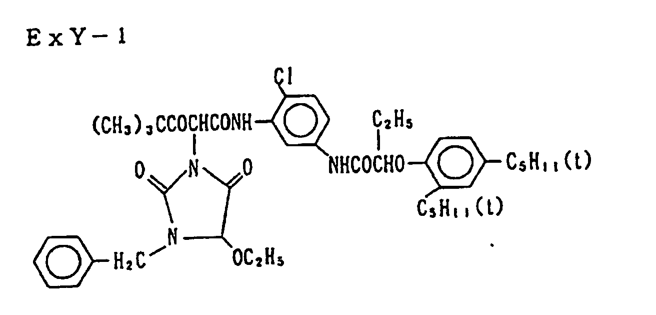

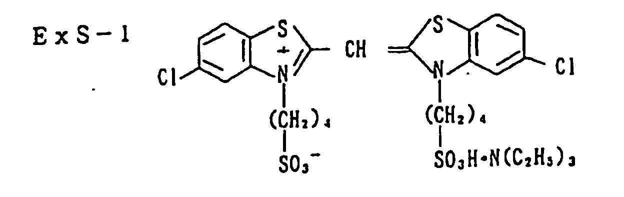

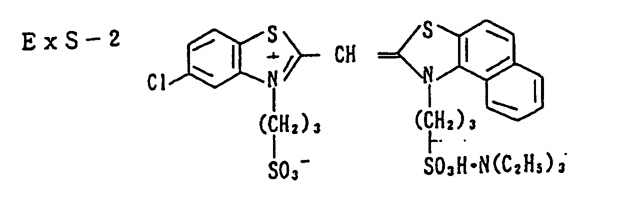

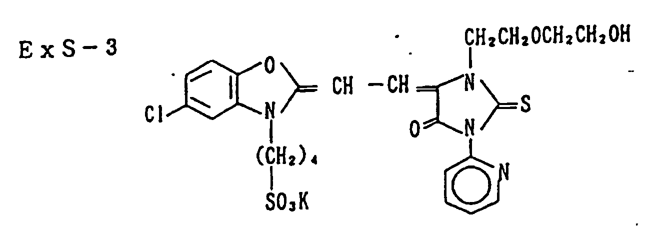

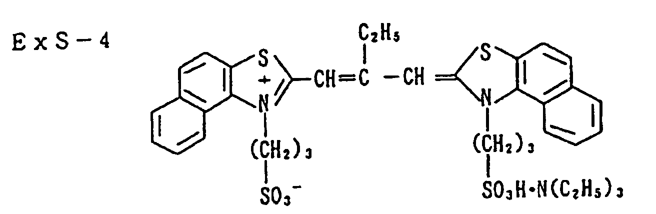

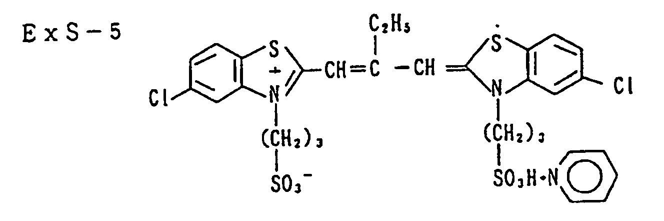

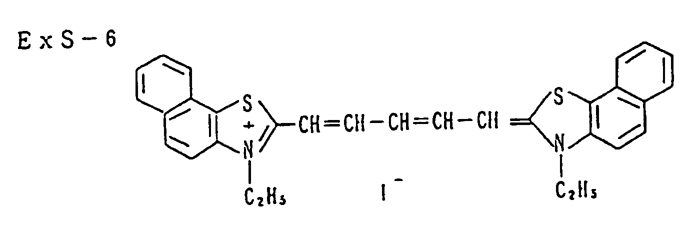

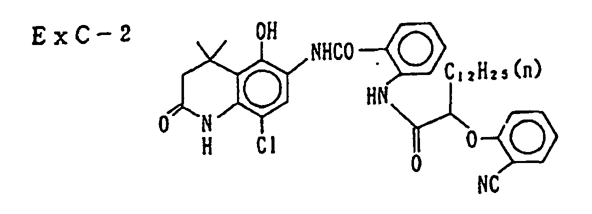

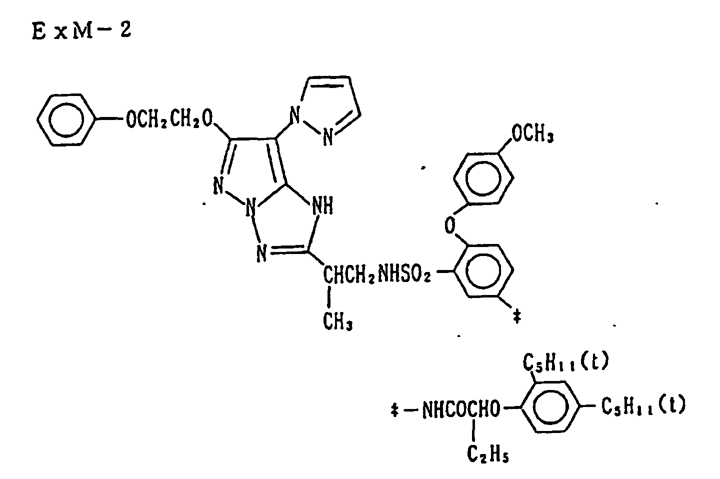

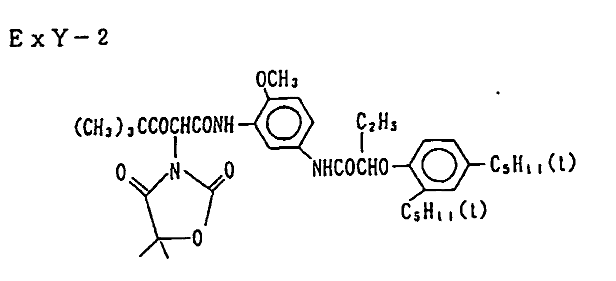

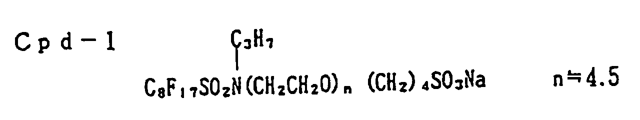

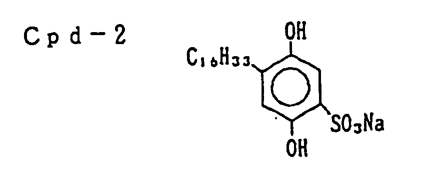

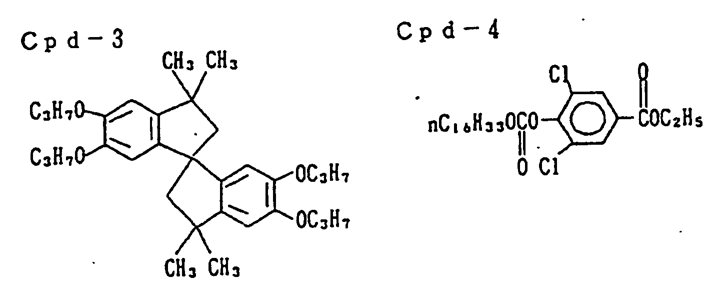

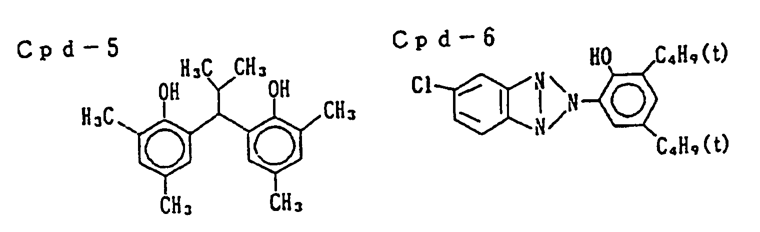

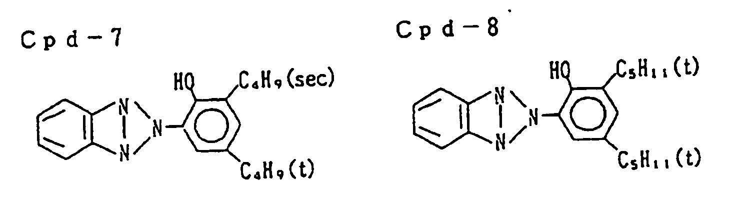

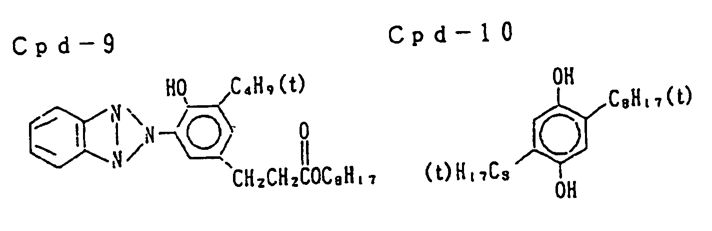

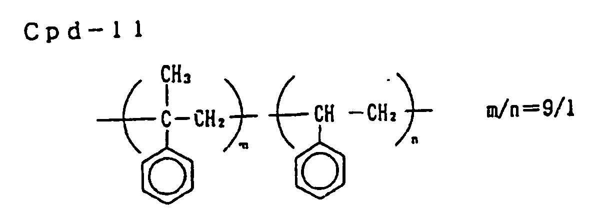

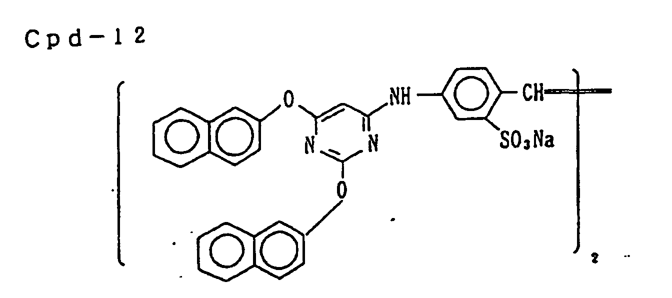

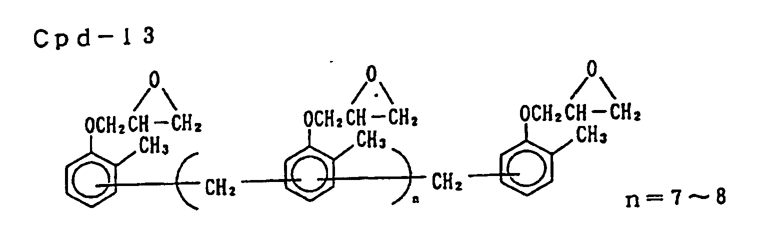

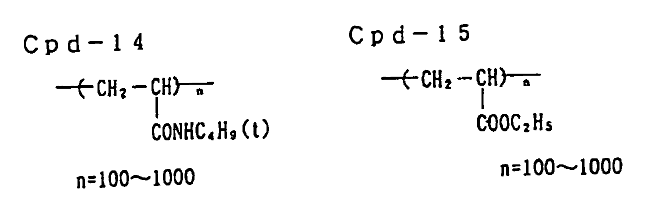

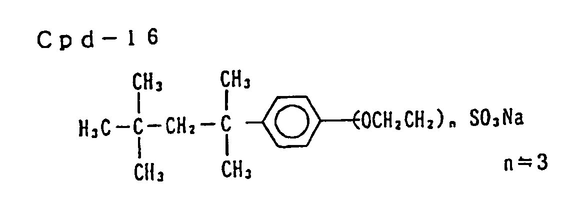

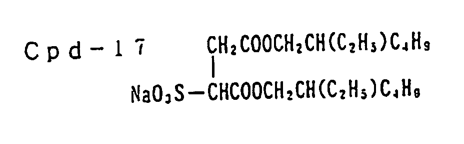

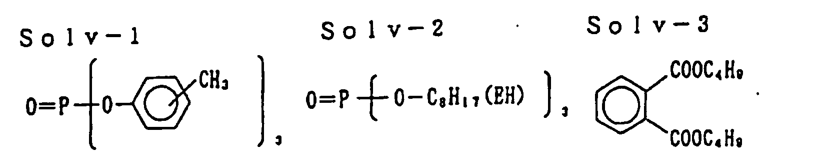

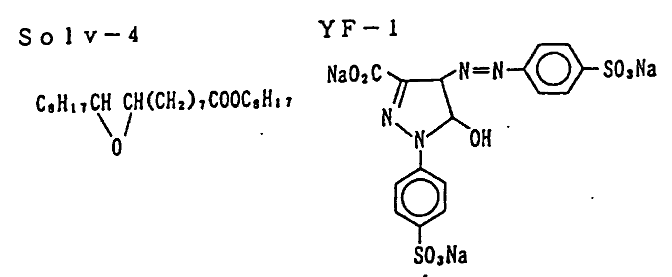

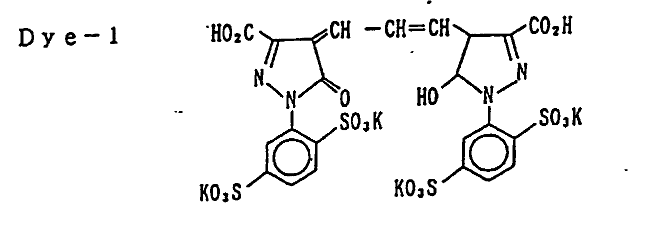

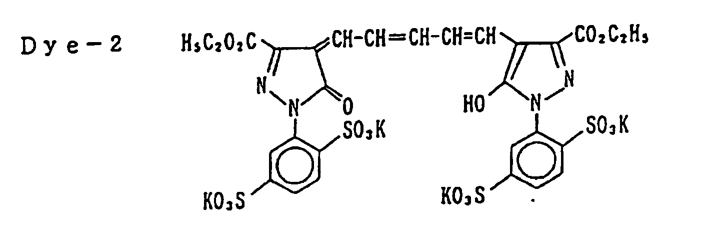

H-1 CH₂=CHSO₂CH₂SO₂CH=CH₂

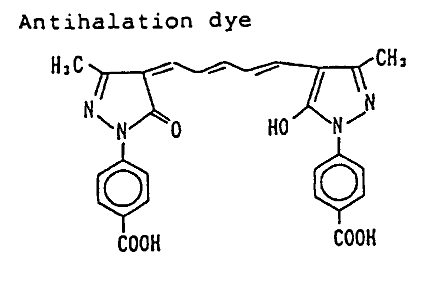

### (8) Processing Step

| Processing Step | Temperature (°C) | Time |
|---|---|---|
| Color development | 38 | 80 sec. |
| Bleach-fixing | 38 | 90 sec. |
| Water washing-1 | 35 | 40 sec. |
| After-hardening | 38 | 3 min. |
| Water washing-2 | 35 | 2 min. |
| Drying | 60 | 2 min. |

Each processing solution had the following composition.

| Color Developer: | |
|---|---|
| Water | 800 ml |
| D-Sorbitol | 0.15 g |
| Sodium naphthalenesulfonate·formalin condensate | 0.15 g |
| Pentasodium nitrotris(methylenephosphonate) | 1.8 g |
| Diethylenetriaminepentaacetic acid | 0.5 g |
| 1-Hydroxyethylidene-1,1-diphosphonic acid | 0.15 g |
| Diethylene glycol | 12.0 ml |
| Benzyl alcohol | 13.5 ml |
| Potassium chloride | 6.5 g |
| Potassium bromide | 0.1 g |
| Potassium carbonate | 30.0 g |
| Sodium sulfite | 2.4 g |
| Disodium N,N-bis(sulfonatoethyl)-hydroxylamine | 8.0 g |
| Triethanolamine | 6.0 g |
| Benzotriazole | 0.01 g |
| N-Ethyl-N-(β-methanesulfonamidoethyl)-3-methyl-4-aminoaniline 3/2 sulfate monohydrate | 6.0 g |
| Water to make | 1 ℓ |
| pH (25°C) | 10.6 |

| Bleach-Fixing Solution: | |
|---|---|
| Water | 600 ml |
| Ammonium thiosulfate (750 g/ℓ) | 160 ml |
| Ammonium sulfite | 40.0 g |
| Ammonium ethylenediaminetetraacetato ferrate | 55.0 g |
| Ethylenediaminetetraacetic acid | 5.0 g |
| Ammonium nitrate | 10.0 g |
| Ammonium bromide | 25.0 g |
| Water to make | 1 ℓ |
| pH (25°C) | 6.0 |

### Washing Water:

Deionized water having an electric conductivity of 5 µS or less

### After-Hardening Solution:

Aqueous solution containing 10% of glutaraldehyde.

Then, an ITO layer having a thickness of 0.1 µm was formed on the protective layer by a sputtering method. The ITO layer was patterned by a photoresist method in conformity with the stripe pattern on the color filter.

Onto the ITO electrode, a coating solution obtained by dissolving 2 g of PVK in 100 mℓ of dichloromethane, and then dissolving 30% by weight of PBD, 3 mol% of TPB, 0.04 mol% of coumarine-6, 0.02 mol% of DCM1 and 0.015 mol% of Nile red in the solution (see "Appl. Phys. Lett., Vol. 67, No. 16, page 2281, 1995) was then coated to form a white light-emitting layer having a dry thickness of 0.16 µm.

Onto the thus formed white light-emitting layer, magnesium and silver were co-evaporated stripewise and crosswise with respect to the ITO electrode (anode) to thereby form an Mg/Ag electrode having a thickness of 0.2 µm and an Mg/Ag molar ratio of 10/1. Onto the Mg/Ag electrode, silver was then singly evaporated to a thickness of 0.2 µm to form a back electrode (cathode). A d.c. voltage was then applied across the thus prepared EL device for every pixel to cause emission of white light, which then passes through the color filter to give an RGB full color display.

In accordance with the present invention, a color filter layer is formed by using a silver halide color light-sensitive layer on a transparent substrate. Subsequently, a transparent electrode is provided on the color filter layer. A polymer compound is incorporated in an organic compound layer to be provided between the transparent electrode and a back electrode. This arrangement allows most of the production steps to be effected in a coating process. Thus, a full color display comprising an EL device can be efficiently produced at a low cost.

While the invention has been described in detail and with reference to specific examples thereof, it will be apparent to one skilled in the art that various changes and modifications can be made therein without departing from the scope thereof.

## Claims

1. An electroluminescence device comprising a transparent flexible plastic substrate having thereon at least:
(i) a color filter layer;
(ii) a water-impermeable protective layer;
(iii) a transparent electrode;
(iv) at least one organic compound layer including a light-emitting layer, said organic compound layer containing a polymer compound; and a back electrode, in this order,
wherein said color filter layer has red, green and blue pixel patterns obtainable by a process comprising:
applying a coating solution of a silver halide photographic layer onto said transparent flexible plastic substrate to form a photographic material having at least three sensitive layers comprising a magenta coupler and a cyan coupler incorporated in a blue-sensitive emulsion layer,
a yellow coupler and a cyan coupler incorporated in a green-sensitive emulsion layer,
a yellow coupler and a magenta coupler incorporated in a red-sensitive emulsion layer as the color filter layer;
patternwise exposing said silver halide color photographic material to light; and then
subjecting the exposed silver halide color photographic material to color development; and
wherein the transparent electrode is coated with a solution containing a polymer compound to form the organic compound layer.

2. The electroluminescence device according to claim 1, wherein said at least one organic compound layer comprises a white light-emitting layer and at least one of a hole-transporting layer and an electron-transporting layer.

3. The electroluminescence device according to claim 1 or 2, wherein said light-emitting layer comprises at least one emitting material molecularly dispersed in a polymer.

4. The electroluminescence device according to any of claims 1 to 3, wherein said at least one organic compound layer contains at least one light-emitting polymer material.

5. The electroluminescence device according to any of claims 1 to 4, wherein said silver halide color photographic material comprises at least three color light-sensitive layers having color sensitivities different from one another.

6. The electroluminescence device according to any of claims 1 to 5, wherein said color filter layer further has a black matrix.

7. A process for producing an electroluminescence device comprising a transparent flexible plastic substrate having thereon at least:
(i) a color filter layer having red, green and blue pixel patterns;
(ii) a water-impermeable protective layer;
(iii) a transparent electrode;
(iv) at least one organic compound layer including a light-emitting layer, said organic compound layer containing a polymer compound; and a back electrodein this order,
which process comprises pixel pattern formation comprising:
applying a coating solution of a silver halide photographic layer onto a transparent substrate to form a photographic material having at least three sensitive layers comprising a magenta coupler and a cyan coupler incorporated in a blue-sensitive emulsion layer,
a yellow coupler and a cyan coupler incorporated in a green-sensitive emulsion layer,
a yellow coupler and a magenta coupler incorporated in a red-sensitive emulsion layer as the color filter layer;
patternwise exposing said silver halide color photographic material to light; and then
subjecting the exposed silver halide color photographic material to color development, to thereby form said pixel patterns on said transparent substrate; and
wherein the transparent electrode is coated with a solution containing a polymer compound to form the organic compound layer.

## Patentansprüche

1. Elektrolumineszente Vorrichtung umfassend ein transparentes, flexibles Kunststoffsubstrat, auf welchem wenigstens angeordnet ist:
(i) eine Farbfilterschicht;
(ii) eine wasserundurchlässige Schutzschicht;
(iii) eine transparente Elektrode;
(iv) wenigstens eine Schicht einer organischen Verbindung, einschließlich einer lichtemittierenden Schicht, wobei die Schicht der organischen Ver bindung eine Polymerverbindung enthält; und eine hintere Elektrode, in dieser Reihenfolge,
wobei die Farbfilterschicht rote, grüne und blaue Pixelmuster aufweist, die durch ein Verfahren erhaltbar sind, umfassend:
Aufbringen einer Beschichtungslösung aus einer fotografischen Silberhalogenidschicht auf das transparente, flexible Kunststoffsubstrat, um ein fotografisches Material mit wenigstens drei empfindlichen Schichten zu bilden, umfassend einen Magentakuppler und einen Cyankuppler enthalten in einer blauempfindlichen Emulsionsschicht,
einen Gelbkuppler und einen Cyankuppler enthalten in einer grünempfindlichen Emulsionsschicht
einen Gelbkuppler und einen Magentakuppler enthalten in einer rotempfindlichen Emulsionsschicht, als die Farbfilterschicht;
musterweise Belichten des farbfotografischen Silberhalogenidmaterial durch Licht; und anschließend
Unterwerfen des belichteten farbfotografischen Silberhalogenidmaterials einer Farbentwicklung; und
wobei die transparente Elektrode mit einer Lösung beschichtet wird, enthaltend eine Polymerverbindung um die Schicht der organischen Verbindung zu bilden.

2. Elektrolumineszente Vorrichtung gemäß Anspruch 1, wobei die wenigstens eine Schicht der organischen Verbindung eine weißes Licht emittierende Schicht und wenigstens eine aus einer Loch transportierenden Schicht und eine elektronenleitenden Schicht umfasst.

3. Elektrolumineszente Vorrichtung gemäß Anspruch 1 oder 2, wobei die lichtemittierende Schicht wenigstens ein emittierendes Material umfasst, welches molekular in einem Polymer dispergiert ist.

4. Elektrolumineszente Vorrichtung gemäß einem der Ansprüche 1 bis 3, wobei die wenigstens eine Schicht der organischen Verbindung wenigstens ein lichtemittierendes Polymermaterial enthält.

5. Elektrolumineszente Vorrichtung gemäß einem der Ansprüche 1 bis 4, wobei das farbfotografische Silberhalogenidmaterial wenigstens drei lichtempfindliche Schichten umfasst, welche sich voneinander unterscheidenden Farbempfindlichkeiten aufweisen.

6. Elektrolumineszente Vorrichtung nach einem der Ansprüche 1 bis 5, wobei die Farbfilterschicht des Weiteren eine schwarze Matrix aufweist.

7. Verfahren zur Erzeugung einer elektrolumineszenten Vorrichtung umfassend ein transparentes flexibles Kunststoffsubstrat, auf welchem wenigstens angeordnet ist:
(i) eine Farbfilterschicht mit roten, grünen und blauen Pixelmustern;
(ii) eine wasserundurchlässige Schutzschicht;
(iii) eine transparente Elektrode;
(iv) wenigstens eine Schicht einer organischen Verbindung umfassend eine lichtemittierenden Schicht, wobei die Schicht der organischen Verbindung eine Polymerverbindung enthält; und eine hintere Elektrode, in dieser Reihenfolge,
wobei das Verfahren, welches die Bildung des Pixelmusters umfasst, umfasst:
Aufbringen einer Beschichtungslösung aus einer fotografischen Silberhalogenidschicht auf ein transparentes Substrat, um ein fotografisches Material mit wenigstens drei empfindlichen Schichten zu bilden, umfassend einen Magentakuppler und einen Cyankuppler, welche in einer blauempfindlichen Emulsionsschicht enthalten sind,
einen Gelbkuppler und einen Magentkuppler, welche in einer grünempfindlichen Emulsionsschicht enthalten sind,
einen Gelbkuppler und einen Magentakuppler, welche in einer rotempfindlichen Emulsionsschicht vorhanden sind, als die Farbfilterschicht;
musterweises Belichten des farbfotografischen Silberhalogenidmaterials durch Licht; und anschließend
Unterwerfen des belichteten farbfotografischen Silberhalogenidmaterials einer Farbentwicklung, wodurch die Pixelmuster auf dem transparenten Substrat gebildet werden; und
wobei die transparente Elektrode mit einer Lösung beschichtet wird, enthaltend eine Polymerverbindung, um die Schicht der organischen Verbindung zu bilden.

## Revendications

1. Dispositif électroluminescent comprenant un substrat en plastique souple transparent comportant sur celui-ci au moins :
(i) une couche de filtre coloré ;
(ii) une couche de protection imperméable à l'eau ;
(iii) une électrode transparente ;
(iv) au moins une couche de composé organique comprenant une couche émettrice de lumière, ladite couche de composé organique contenant un composé polymère ; et une électrode arrière, dans cet ordre,
dans lequel ladite couche de filtre coloré comporte des motifs de pixels rouges, verts et bleus pouvant être obtenus grâce à un procédé comprenant les étapes consistant à :
appliquer une solution de revêtement d'une couche photographique d'halogénure d'argent sur ledit substrat en plastique souple transparent pour former un matériau photographique comportant au moins trois couches sensibles comprenant un coupleur magenta et un coupleur cyan incorporés dans une couche d'émulsion sensible au bleu ;
un coupleur jaune et un coupleur cyan incorporés dans une couche d'émulsion sensible au vert,
un coupleur jaune et un coupleur magenta incorporés dans une couche d'émulsion sensible au rouge en tant que couche de filtre coloré ;
exposer dans le sens du motif ledit matériau photographique coloré d'halogénure d'argent à la lumière ; puis
soumettre le matériau photographique coloré d'halogénure d'argent exposé à un développement chromogène ;
dans lequel l'électrode transparente est revêtue d'une solution contenant un composé polymère pour former la couche de composé organique.

2. Dispositif électroluminescent selon la revendication 1, dans lequel ladite au moins une couche de composé organique comprend une couche émettrice de lumière blanche et au moins une parmi une couche de transport de trous et une couche de transport d'électrons.

3. Dispositif électroluminescent selon la revendication 1 ou 2, dans lequel ladite couche émettrice de lumière comprend au moins un matériau émetteur dispersé de façon moléculaire dans un polymère.

4. Dispositif électroluminescent selon l'une quelconque des revendications 1 à 3, dans lequel ladite au moins une couche de composé organique contient au moins un matériau de polymère émetteur de lumière.

5. Dispositif électroluminescent selon l'une quelconque des revendications 1 à 4, dans lequel ledit matériau photographique coloré d'halogénure d'argent comprend au moins trois couches photosensibles colorées ayant des sensibilités chromatiques différentes les unes des autres.

6. Dispositif électroluminescent selon l'une quelconque des revendications 1 à 5, dans lequel ladite couche de filtre coloré comporte en outre une matrice à fond noir.

7. Procédé de fabrication d'un dispositif électroluminescent comprenant un substrat en plastique souple transparent comportant sur celui-ci au moins :
(i) une couche de filtre coloré comportant des motifs de pixels rouges, verts et bleus ;
(ii) une couche de protection imperméable à l'eau ;
(iii) une électrode transparente ;
(iv) au moins une couche de composé organique comprenant une couche émettrice de lumière, ladite couche de composé organique contenant un composé polymère ; et une électrode arrière, dans cet ordre,
lequel procédé comprend la formation d'un motif de pixels comprenant les étapes consistant à :
appliquer une solution de revêtement d'une couche photographique d'halogénure d'argent sur un substrat transparent pour former un matériau photographique comportant au moins trois couches sensibles comprenant un coupleur magenta et un coupleur cyan incorporés dans une couche d'émulsion sensible au bleu ;
un coupleur jaune et un coupleur cyan incorporés dans une couche d'émulsion sensible au vert,
un coupleur jaune et un coupleur magenta incorporés dans une couche d'émulsion sensible au rouge en tant que couche de filtre coloré ;
exposer dans le sens du motif ledit matériau photographique coloré d'halogénure d'argent à la lumière ; puis
soumettre le matériau photographique coloré d'halogénure d'argent exposé à un développement chromogène, pour former ainsi lesdits motifs de pixels sur ledit substrat transparent ; et
dans lequel l'électrode transparente est revêtue d'une solution contenant un composé polymère pour former la couche de composé organique.
